# EUROPEAN PATENT SPECIFICATION

(11) **EP 4 572 142 B1**
(45) Date of publication and mention of the grant of the patent: **18.11.2026**
(21) Application number: 23216348.5
(22) Date of filing: 13.12.2023
(51) Int. Cl.: H03K 3/84, G06F 7/58

(54) **PROGRAMMABLE DRIVING CIRCUIT FOR TUNABLE PROBABILISTIC BIT ARRAYS**
PROGRAMMIERBARE TREIBERSCHALTUNG FÜR ABSTIMMBARE PROBABILISTISCHE BIT-ARRAYS
CIRCUIT D'ATTAQUE PROGRAMMABLE POUR RÉSEAUX DE BITS PROBABILISTES ACCORDABLES

(43) Date of publication of application: 18.06.2025
(73) Proprietor: Imec VZW, 3001 Leuven (BE); Katholieke Universiteit Leuven KU Leuven Research & Development, 3000 Leuven (BE)
(72) Inventor: GARCIA REDONDO, Fernando, Cambridge, CB43NG (GB); GAMAGE, Sahan, Cambridge, CB1 8NJ (GB); VERHELST, Marian, 2800 Mechelen (BE)
(74) Representative: Winger

(56) References cited:
- US-A1- 2023 070 486
- SUTTON BRIAN ET AL: "Autonomous Probabilistic Coprocessing With Petaflips per Second", IEEE ACCESS, IEEE, USA, vol. 8, 21 August 2020 (2020-08-21), pages 157238 - 157252, XP011807261, DOI: 10.1109/ACCESS.2020.3018682
- KEREM Y CAMSARI ET AL: "p-Bits for Probabilistic Spin Logic", ARXIV.ORG, CORNELL UNIVERSITY LIBRARY, 201 OLIN LIBRARY CORNELL UNIVERSITY ITHACA, NY 14853, 11 September 2018 (2018-09-11), XP081122972, DOI: 10.1063/1.5055860

## Description

### Field of the invention

The present invention generally relates to the field of random bit generation and more particularly relates to programmable electronic driving circuitry auxiliary to the generation of many tunable probabilistic bits in hardware.

### Background of the invention

Controlling multiple tunable probabilistic bits through a programmable analog voltage is known in the art. In Kerem Y. Camsari, Brian M. Sutton, Supriyo Datta: "p-bits for probabilistic spin logic", Appl. Phys. Rev. 1 March 2019; 6 (1): 011305, the authors describe circuits based on p-bits that require a programmable input voltage for each p-bit. In Brian Sutton et al.: "Autonomous Probabilistic Coprocessing With Petaflips per Second", IEEE Access, Vol. 8, 2020, the authors disclose a probabilistic coprocessor including an array of tunable p-bits, each receiving an individual analog bias signal that determines its output probability and allows the behaviour of the p-bit network to be programmed for different computational tasks.

A programmable analog voltage source is necessary to simultaneously generate all the different analog voltage signals. A disadvantage of using conventional programmable analog voltage sources is that a high fan-out is required, the degree of which increases quadratically with the number of p-bits in the circuit. Moreover, the design and layout of the routing network is complicated by the large number of wires to be routed, which also increases quadratically with the number of p-bits for which mean value adjustment is necessary.

### Summary of the invention

It is an object of embodiments of the present invention to provide simpler electronic driver circuits for simultaneously controlling multiple tunable probabilistic bit generators that do not require voltage sources with a high fanout. It is a further object of embodiments of the present invention to provide simpler electronic driver circuits for simultaneously controlling multiple tunable probabilistic bit generators that require less wire connections for voltage signal distribution to the probabilistic bit generators.

The above objective is accomplished by a device and method according to the present invention.

In one aspect, the present invention relates to a programmable driver circuit for the simultaneous control of multiple tunable probabilistic bit generators. Each probabilistic bit generator has an input terminal for individually controlling a statistical expectation of probabilistic bits generated by the probabilistic bit generator. The driver circuit comprised a plurality of programmable voltage generators and a programming unit configured to generate a sequence of programming pulses in accordance with a target level for the output signal to be generated by each voltage generator. Each voltage generator has an input terminal and an output terminal and is configured to generate a respective output signal of the driver circuit, when the voltage generator is operated in a drive mode. The input terminals of the plurality of programmable voltage generators are jointly connectible to a single voltage supply source and the output terminal of each voltage generator is directly connectible to the input terminal of a respective one of the multiple tunable probabilistic bit generators, for driving the output signal generated by the voltage generator to the tunable probabilistic bit generator. Moreover, each voltage generator comprises a single-stage or multi-stage voltage divider circuit that is formed by a series of resistive elements. The resistive element positioned first in the series of resistive elements is operatively connectible to the input terminal, for receiving a supply voltage from the single voltage supply source. The resistive element positioned last in the series of resistive elements is operatively connectible to a fixed reference voltage. The output terminal of the voltage generator is operatively coupled to an electrical connection between two successive resistive elements of the series of resistive elements, whereby a voltage signal at the electrical connection between the two successive resistive elements determines the output signal at the output terminal, when the voltage generator is operated in the drive mode. Each voltage generator further comprises a non-volatile memory unit which comprises at least the resistive element positioned first in the series of resistive elements as a programmable resistance, and a program control transistor connected in series between the programmable resistance and the fixed reference voltage. A control gate of the program control transistor is operatively coupled to the programming unit to receive the sequence of programming pulses for the programmable voltage generator when operated in a programming mode.

In another aspect, the present invention relates to a device for generating multiple tunable probabilistic bits, or p-bits, which device comprises a plurality of tunable probabilistic bit generators, a single voltage supply source and a programmable driver circuit according to embodiments of the previous aspect. Each probabilistic bit generator has an input terminal for individually controlling a statistical expectation of probabilistic bits generated by the probabilistic bit generator. Input terminals of the plurality of programmable voltage generators of the programmable driver circuit are jointly connected to the single voltage supply source. The output terminal of each voltage generator of the programmable driver circuit is directly connected to the input terminal of a respective one of the multiple tunable probabilistic bit generators, for driving the output signal generated by the voltage generator to the tunable probabilistic bit generator.

In yet another aspect, the present invention relates to a method of operating the driver circuit according to embodiments of the previous aspect. The method comprises the steps of:
supplying a single voltage supply signal to the input terminals of the plurality of programmable voltage generators;
connecting the resistive element positioned first in said series of resistive elements of each voltage generator to the input terminal of the voltage generator;
connecting the resistive element positioned last in said series of resistive elements of each voltage generator to a fixed reference voltage; and
disconnecting the control gate of each program control transistor in each voltage generator from the programming unit.

The method of operating the driver circuit may be a method of controlling a mean value associated with each one of a plurality of probabilistic bit generators, which includes the further steps of:
providing a plurality of tunable probabilistic bit generators, each probabilistic bit generator having an input terminal for individually controlling a statistical expectation of probabilistic bits generated by the probabilistic bit generator;
driving the output signals generated by each voltage generator to the input terminal of a respective one of the plurality of tunable probabilistic bit generators.

The method of operating the driver circuit may be a method of programming a mean value associated with each one of a plurality of probabilistic bit generators, which includes the further steps of:
selecting a voltage generator of the plurality of programmable voltage generators for programming a target level for the output signal to be generated by the voltage generator when operated in the drive mode;
generating a sequence of programming pulses in accordance with the target level for the output signal of the selected voltage generator of the previous step;
disconnecting the resistive element positioned last in said series of resistive elements of the selected voltage generator from the fixed reference voltage;
sequentially coupling the programming unit to the control gates of the different program control transistors in the selected voltage generator and driving each control gate with the sequence of programming pulses or part of the sequence of programming pulses generated in the previous step, thereby switching on and off a programming current through the programmable resistance addressed by the program control transistor.

The method of programming a mean value associated with each one of the plurality of probabilistic bit generators may be carried out prior to the method steps related to the controlling of the mean value associated with each one of the plurality of probabilistic bit generators.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, in which:
FIG. 1 shows a driver circuit of the prior art suitable for simultaneously controlling multiple tunable probabilistic bit generators.
FIG. 2 to FIG. 4 are circuit diagrams of different programmable voltage generator that can be used in driver circuits in accordance with embodiments of the invention.
FIG. 5 shows a driver circuit for simultaneously controlling multiple tunable probabilistic bit generators according to an embodiment of the invention.
FIG. 6 illustrates steps of a method for simultaneously controlling multiple tunable probabilistic bit generators.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

Directional terminology such as top, bottom, front, back, leading, trailing, under, over and the like in the description and the claims is used for descriptive purposes with reference to the orientation of the drawings being described, and not necessarily for describing relative positions. Because components of embodiments of the present invention can be positioned in a number of different orientations, the directional terminology is used for purposes of illustration only, and is in no way intended to be limiting, unless otherwise indicated. It is, hence, to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art.

In the description provided herein, numerous specific details are set forth. However, it is understood that embodiments of the invention may be practiced without these specific details. In other instances, well-known methods, structures and techniques have not been shown in detail in order not to obscure an understanding of this description.

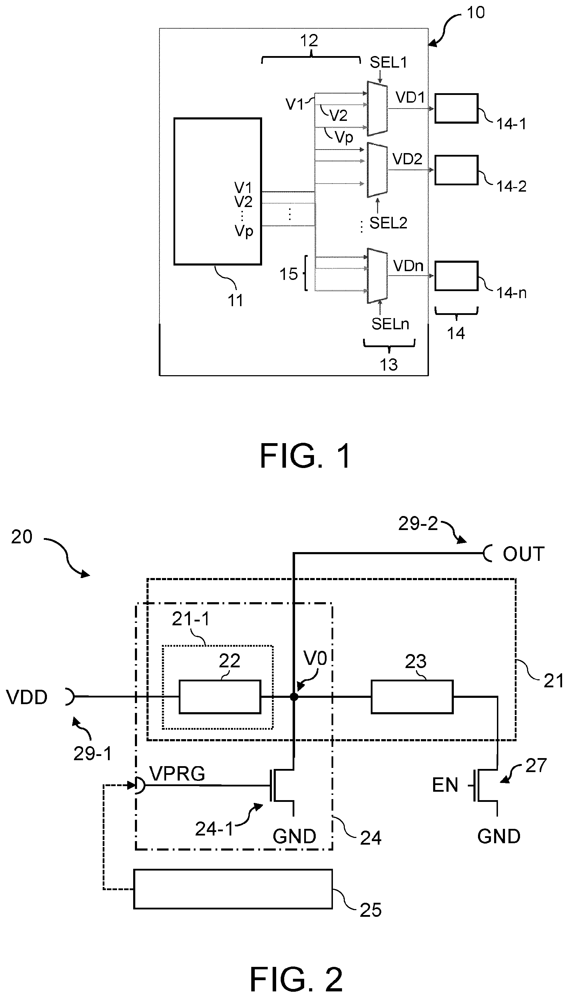

Electronic circuits for simultaneously controlling multiple tunable probabilistic bits as known in the art rely on a programmable analog voltage source for the simultaneous generation of the different analog signals that control the mean value (statistical expectation) of the various probabilistic bit generators. An example of such a driver circuit 10 of the prior art is shown in FIG. 1, in which an analog voltage source 11 supplies up to 'p' voltage signals of different amplitudes, V1, V2, ..., Vp, as output signals. A wired routing network 12 and a selection stage 13 are connected between the analog voltage source 11 and an array of the probabilistic generators 14 and used to distribute the p output signals toward each one of the probabilistic bit generators 14-1 to 14-n. More specifically, a bundle 15 of 'p' distinct output signals is routed toward a respective multiplexing circuit of the selection stage 13, which is preceding each probabilistic that generator of the array, in order to select the output signal of the bundle of output signals that is needed for driving the probabilistic bit generator by an appropriate select signal. In the embodiment of the prior art, select signals SEL1, ..., SELn are provided to select corresponding voltage signals VD1, VD2, ..., VDn from the respective bundle of voltage source output signals, which are driven to the separate probabilistic bit generators 14-1 to 14-n of the array 14. A disadvantage of this type of driver circuit is that it requires a high fan-out for the analog voltage source, the degree of which increases quadratically with the number of probabilistic generators in the array. Moreover, the design and layout of the routing network is complicated by the large number of wires to be routed, which also increases quadratically with the number of probabilistic bit generators in the array.

Therefore, the inventors endeavored to overcome the aforementioned disadvantages and provide simpler electronic driver circuit for simultaneously controlling multiple tunable probabilistic bit generators that does not require output signals of different voltage amplitudes to be generated by a single voltage source and that requires less wire connections for voltage signal distribution to the probabilistic bit generators.

In embodiments of the invention, this has been solved by providing a separate programmable (single-)voltage generator for each tunable probabilistic bit generator to be controlled. Each programmable voltage generator supplies an output signal (e.g., output voltage or output current) that is suitable for controlling the statistical expectation of a sequence of probabilistic bits as generated by an individual tunable probabilistic bit generator, e.g., through an control input terminal of the probabilistic bit generator. That is, the output signal voltage/current supplied by the programmable voltage generator, when operated in a drive mode, is used as a control signal that causes the tuning of the statistical expectation of a sequence of probabilistic bits generated by the tunable probabilistic bit generator that is receiving the output voltage from the programmable voltage generator. Multiple programmable voltage generators, which can be powered by a common supply voltage, are then provided to drive respective tunable probabilistic bit generators of a plurality of tunable probabilistic bit generators, e.g. an array of tunable probabilistic bit generator. Each programmable voltage generator comprises a voltage divider circuit that is composed of a series of resistive elements, which are arranged into one or multiple divider stages. A divider stage of the voltage divider circuit is defined as a resistive element or group of resistive elements with respect to which a voltage signal can be tapped out. That is, a signal tap is associated with each divider stage, which enables the supply of a voltage signal that is a (divided) portion of an input voltage signal applied across the whole of the voltage divider circuit. The resistive element of a first divider stage of the voltage divider circuit, positioned first in said series of resistive elements, is operatively connectible to an input terminal of the programmable voltage generator for receiving the common supply voltage, e.g., as generated by a single voltage source that is shared by all programmable voltage generator of the driver circuit. Hence, the input terminals of the plurality of programmable voltage generators are jointly connectible to a single voltage supply source. The resistive element positioned last in said series of resistive elements of the voltage divider circuit is operatively connectible to a fixed reference voltage, e.g., a ground level of the diver circuit. An output terminal of the programmable voltage generator, directly connectible to the input terminal of a respective one of the multiple tunable probabilistic bit generators, is supplying the output signal to be driven to the corresponding tunable probabilistic bit generator, when the programmable voltage generator is operated in the drive mode. The output terminal is operatively coupled to an electrical connection between two successive resistive elements of the series of resistive elements of the voltage divider circuit, whereby a voltage signal at this electrical connection between the two successive resistive elements determines the output signal at the output terminal when the voltage generator is operated in the drive mode. Typically, the output terminal is operatively coupled to an electrical connection between the resistive element of the last programable divider stage and a reference resistor (e.g. fixed resistor) being the resistive element positioned last in the series of resistive elements of the voltage divider circuit. Alternatively, the output terminal is operatively coupled to an electrical connection between the resistive element of the last programable divider stage and the resistive element of the first non-programmable divider stage.

At least the first divider stage of the voltage divider circuit is programmable, i.e., the resistive element of this first stage is a programmable resistance. Programmable divider stages of the voltage divider circuit are associated with non-volatile memory cells of a non-volatile memory unit. More specifically, each memory cell of the memory unit comprises the programmable resistance of the programmable divider stage and a program control transistor that is connected in series between the programmable resistance and the fixed reference voltage, e.g., a ground level of the diver circuit. A control gate of the program control transistor is operatively coupled to a programming unit when the programmable voltage generator is operated in a programming mode. This allows the programming of the programmable resistance of the memory cell. That is, a resistance value of the programmable resistance of the memory cell can be set to a desired resistance value as determined by a sequence of programming pulses received at the control gate of the program control transistor of the programmable voltage generator when operated in the programming mode. Moreover, a programming unit of the driver circuit is configured to generate the sequences of programming pulses in accordance with a targeted output level for the output signal to be generated by each voltage generator. One or multiple sequences of programming pulses may be generated by the programming unit with respect to each programmable voltage generator, depending on the number of programmable divider stages of the voltage divider circuit and the currently programmed resistance values related to these divider stages. If different sequences of programming pulses are generated by the programming unit with respect to one of the programmable voltage generators that has multiple programmable divider stages, one or multiple components of a selection circuit of the driver circuit, under the control of the programming unit or a separate control unit, may be used to individually address the different control gates of the program control transistors of the programmable voltage generator and sequentially apply the different sequences of programming pulses to the respective control gates of the program control transistors.

Providing programmable voltage generators in accordance with embodiments of the invention solves the problem of the quadratic increase in the number of routing wires in the prior art. The programmable voltage generators of the driver circuit being jointly connectible to a single voltage supply source, the number of wires only increases linearly with the number of programmable voltage generator, and consequently also increases linearly with the number of probabilistic bit generators that need to be controlled. Moreover, no specially designed and/or programmable voltage supply source that is common to the programmable voltage generator is required. A simpler voltage supply source that delivers only a single, e.g. fixed, level of supply voltage may be used instead. Furthermore, no complex selection circuitry is required to select among a number of different output voltages, since every programmable voltage generator of the driver circuit directly supplies one of the different output voltages required for controlling the statistical expectation of the probabilistic bit sequences generated by the probabilistic bit generators. The invention also provides a way to decouple the tuning and sampling stages for probabilistic bits into different functional circuits.

Programmable voltage generators in accordance with embodiments of the invention can advantageously be used as basic building blocks. Replicas of the building block are then used to assemble the full driver circuit, which allows for a simplified design. Moroevr, faulty voltage generators of the driver circuit may be detected and discarded during use, e.g., disabled or inactivated when the driver circuit is operating in the drive mode, without fully compromising the desired control functionality of the driver circuit with regard to the tunable probabilistic bit generators.

Programmable voltage generators in accordance with embodiments can be programmed on demand and persistently store the programmed resistance values in the voltage divider circuit thereafter. No reprogramming is needed if the driver circuit and its programmable voltage generators are temporally disabled. This saves energy and renders the driver circuit quickly operational in the drive mode after a quiescent phase. Moreover, the programmable resistance of memory cells associated with programmable divider stages of the voltage divider circuit can be programmed very accurately.

In embodiments of the invention, a control unit may of the driver circuit may be configured to switch the driver circuit's mode of operation between the drive mode and the programming mode. The control unit may be configured to generate and a set of control signals for each mode of operation and apply the control signals to the programmable voltage generators and the programming unit. In some embodiments of the invention, the control unit may also act as the programming unit of the driver circuit. A driver circuit according to embodiments of the invention may comprise more than one programming unit, e.g., multiple programming units, wherein each programming unit is operatively coupled to a subset of the plurality of programmable voltage generators. This allows faster, parallel programming of a subset of the programmable voltage generators, e.g. parallel programming of all the programmable voltage generators.

According to some embodiments of the invention, at least one of the programmable voltage generators of the driver circuit, e.g. each programmable voltage generator, may comprise a voltage follower circuit, current follower circuit or a transconductance amplifier circuit interposed between the output terminal of the programmable voltage generator and the electrical connection between the two successive resistive elements of the series of resistive elements of the programmable voltage generator. This has the beneficial effect of isolating the output signal from the voltage signal at the electrical connection between the two successive resistive elements of the series of resistive elements of the programmable voltage generator. A current flowing through the series of resistive elements of the voltage divider circuit becomes virtually independent of the load current flowing into the corresponding probabilistic bit generator. Therefore, the magnitude of the current flowing through the series of resistive elements of the voltage divider circuit can be made small by design of the voltage divider circuit, which reduces the power consumption of the driver circuit when it is operated in the drive mode. Likewise, output signal variations as a result of varying load impedance variations, e.g., varying input impedance of the probabilistic bit generator as a function of the mean value as tuning parameter, are strongly reduced or fully suppressed if the output signal is isolated from the voltage signal at the electrical connection between the two successive resistive elements of the series of resistive elements of the programmable voltage generator.

In accordance with some embodiments of the invitation, each programmable voltage generator of the driver circuit may further comprise a pair of access transistors: a first access transistor for operatively connecting the resistive element positioned first in said series of resistive elements to the single voltage supply source and a second access transistor for operatively connecting the resistive element positioned last in said series of resistive elements to the fixed reference voltage. This allows a controlled enabling and disabling of the output signal at the output terminal of each programmable voltage generator of the driver circuit, as well as any current flowing through the voltage divider circuit of each programmable voltage generator of the driver circuit. The pair of access transistor is enabled (i.e. switched on, in a conducting mode) if the driver circuit is operated in the drive mode. A quiescent mode for power savings of the driver circuit may correspond to the situation where the pair of access transistor is disabled (i.e. switched off, in a non-conducting mode).

In embodiments of the invention, the common supply voltage may be regulated to adapt the driver circuit to different possible input ranges with respect to the control input terminals of the probabilistic bit generators, which may depend on the targeted application and/or hardware used to implement the probabilistic bit generators that need to be tuned. Alternatively, additional resistive elements, e.g. resistors, may be inserted into the series of resistive elements of the voltage divider circuit, which also provides the effect of adapting the output range for the output signals generated at the output terminals of the plurality of programmable voltage generators of the driver circuit. For instance, the programmable resistance of the first divider stage of the voltage divider circuit may be a compound resistance, which comprises a programmable resistive element and a resistor in series, or an additional resistor may be added to a reference resistance being the last resistive element of the series of resistive elements that is operatively connected to the fixed reference voltage. In this case, the reference resistance is a compound resistance, which comprises the last resistive element of the series of resistive elements and one or more additional resistive elements (e.g., resistors).

In embodiments of the invention, the programmable resistances of the non-volatile memory cells associated with the programmable divider stages of the voltage divider circuits in each programmable voltage generator of the driver circuit may be one of the following elements: phase-change memory-based memristors, resistive RAM-based memristors, conductive-bridge RAM-based memristors. These types of programmable resistive elements allow accurate programming of its resistance value to any analog value comprised in a continuous range of permitted resistance values, e.g., a permitted range of analog programmable resistance values between a minimum resistance value and a maximum resistance value.

In embodiments of the invention, the programmable resistances of the non-volatile memory cells associated with the programmable divider stages of the voltage divider circuits in each programmable voltage generator of the driver circuit may be a switchable magnetoresistance, e.g., the magnetoresistance of a magnetic tunnel junction (MTJ). In this case, the resistance value of the programmable resistive elements can be programmed digitally to one or more intermediate resistance values in a permitted range of resistance values, i.e., a discrete set of resistance values comprised between a minimum resistance value and a maximum resistance value.

A programmable voltage generator which can be used in driver circuits in accordance with embodiments of the invention is now described with reference to FIG. 2. The programmable voltage generator 20 comprises a single-stage voltage divider circuit 21 that is composed of two series-connected resistive elements 22, 23. The first resistive element 22 of the voltage divider circuit 21 is associated with a first and only divider stage 21-1 of the single-stage voltage divider circuit 21. This first divider stage is programmable, i.e. its resistance can be altered by way of programming. A first terminal of the first resistive element 22 is connected to an input terminal 29-1 of the programmable voltage generator 20 that is connectible to a supply voltage 'VDD'. A second terminal of the first resistive element 22 is connected through an electrical connection to a first terminal of the second resistive element 23. This second resistive element 23 may be a fixed reference resistance, e.g. a fixed reference resistor. An access transistor 27 operatively connects a second terminal of the second resistive element 23 to a fixed reference voltage of the driver circuit, e.g. the ground voltage level 'GND' in the present embodiment. When driven to the control gate of the access transistor 27, an enable signal 'EN' causes the access transistor to switch on, thereby coupling the second resistive element 23 to the fixed reference voltage 'GND'. Access transistor 27 may be of any size. The purpose of access transistor 27 is to limit leakage currents and provide individual programmability of the programmable divider stages of the voltage divider circuit when the driver circuit is operated in programming mode. An output terminal 29-2 of the programmable voltage generator 20 supplies the output signal 'OUT' when the driver circuit is operated in the drive mode. The output terminal 29-2 is directly connected to the electrical connection between the first resistive element 22 and the second resistive element 23. Hence, a voltage signal 'V0' at that electrical connection directly determines the output voltage signal 'OUT' of the programmable voltage generator. The programmable voltage generator also comprises a non-volatile memory unit which, in the present embodiment, consists of a single non-volatile memory cell 24. The non-volatile memory cell 24 includes the programmable first resistive element 22 and a program control transistor 24-1 connected between the second terminal of the first resistive element 22 and the fixed reference voltage 'GND'. A programming signal 'VPRG' acts onto the control gate of the program control transistor 24-1 when the driver circuit is operated in the programming mode, thus controlling a programming current flowing from the input terminal 29-1 through the programmable resistive element 22 and the channel of the program control transistor 24-1 to the fixed reference potential 'GND'. The programming signal 'VPRG' - a sequence of programming voltage pulses - is supplied by a programming unit 25 when the driver circuit is operated in the programming mode. The programming unit 25 or a separate control unit of the driver circuit determines the set of control signals needed to switch modes of operation, e.g., switch between the drive mode and the programming mode of the driver circuit. The programming unit 25 may be part of the programmable voltage generator 20 or may be a global or semiglobal programming unit of the driver circuit, meaning that is shared by all or a subset of the multiple programmable voltage generators of the driver circuit.

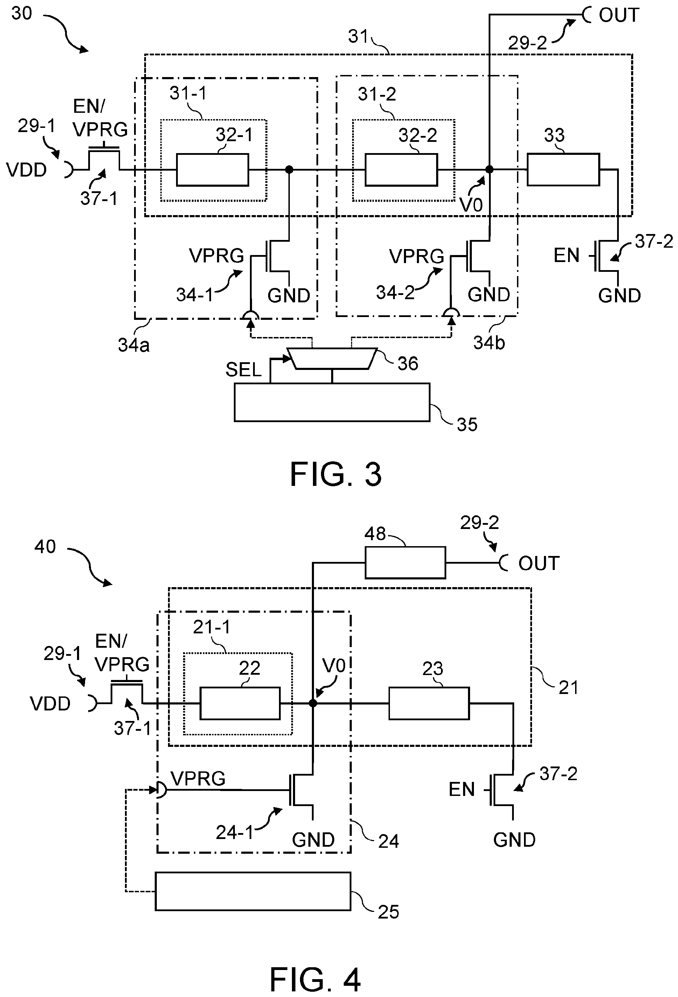

FIG. 3 shows an alternative programmable voltage generator that can be used in driver circuits in accordance with embodiments of the invention. The programmable voltage generator 30 comprises a two-staged voltage divider circuit 31 that is composed of three series-connected resistive elements 32-1, 32-2 and 33. The first resistive element 32-1 and the second resistive element 32-2 of the voltage divider circuit 31 are associated with a first divider stage 31-1 and a second divider stage 31-2 of the two-staged voltage divider circuit 31, respectively. This first divider stage 31-1 and the second divider stage 31-2 are programmable, i.e. their respective resistances can be altered by way of programming. A first terminal of the first resistive element 32-1 is operatively connected, through a first access transistor 37-1, to an input terminal 29-1 of the programmable voltage generator 30, which is connectible to a supply voltage 'VDD'. A second terminal of the first resistive element 32-1 is connected to a first terminal of the second resistive element 32-2. A second terminal of the second resistive element 32-2 is connected through an electrical connection to a first terminal of the third resistive element 33. This third resistive element 33 may be a fixed (i.e. non-programmable) reference resistance, e.g. a fixed reference resistor. A second access transistor 37-2 operatively connects the second terminal of the third resistive element 33 to a reference voltage of the driver circuit, e.g. the ground voltage level 'GND' in the present embodiment. When driven to the respective control gates of the first and second access transistors 37-1 and 37-2, an enable signal 'EN' causes the two access transistors 37-1 and 37-2 to switch on, thereby coupling the first resistive element 32-1 to the supply voltage 'VDD' and the third resistive element 33 to the fixed reference voltage 'GND', respectively. An output terminal 29-2 of the programmable voltage generator 30 supplies the output signal 'OUT' when the driver circuit is operated in the drive mode. The output terminal 29-2 is directly connected to the electrical connection between the second resistive element 32-2 and the third resistive element 33. Hence, a voltage signal 'V0' at that electrical connection directly determines the output voltage signal 'OUT' of the programmable voltage generator. The programmable voltage generator also comprises a non-volatile memory unit which, in the present embodiment, contains two non-volatile memory cells 34a and 34b. The non-volatile memory cell 34a is associated with the first programmable divider stage 31-1 and includes the programmable first resistive element 32-1 and a program control transistor 34-1 connected between the second terminal of the first resistive element 32-1 and the fixed reference voltage 'GND'. Similarly, the non-volatile memory cell 34b is associated with the second programmable divider stage 31-2 and includes the programmable second resistive element 32-2 and a further program control transistor 34-2 connected between the second terminal of the second resistive element 32-2 and the fixed reference voltage 'GND'. A programming signal 'VPRG' acts separately onto either one but not both control gates of the program control transistors 34-1 and 34-2, when the driver circuit is operated in the programming mode. Applying a second programming signal to the control gate of the second program control transistor 34-2 allows to control a second programming current that flows from the input terminal 29-1 through the first and second programmable resistive elements 32-1, 32-2, and further through the channel of the second program control transistor 34-2, towards the fixed reference potential 'GND'. Applying a first programming signal to the control gate of the first program control transistor 34-1 allows to control a first programming current that flows from the input terminal 29-1 through the first programmable resistive elements 32-1 and the channel of the first program control transistor 34-1 towards the fixed reference potential 'GND'. The two separately applicable programming signal 'VPRG' are sequences of programming voltage pulses and supplied by a programming unit 35 when the driver circuit is operated in the programming mode. The program control transistors of voltage divider stages not subjected to programming are switched off, e.g., by disconnecting the control gates from the programming unit or configuring the programming unit to supply a below-threshold voltage to the control gates. This leaves the resistive elements of the voltage divider stages not subjected to programming, and subsequent to a voltage divider stage being programmed, in a floating state. No programming currents will thus enter those resistive elements. During the programming phases of the programmable divider stages of the voltage divider circuit, a voltage applied to the control gate of the first access transistor 37-1 may be kept above threshold voltage, or may be synchronized with the respective programming signal 'VPRG'. The programming unit 35 or a separate control unit of the driver circuit 30 determines the set of control signals needed to switch modes of operation, e.g., switch between the drive mode and the programming mode of the driver circuit. The programming unit 35 may be part of the programmable voltage generator 30 or may be a global or semiglobal programming unit of the driver circuit, meaning that is shared by all or a subset of the multiple programmable voltage generators of the driver circuit. In the present embodiment, an appropriate selection logic circuitry 36, e.g. a multiplexor or multiplexor tree structure, may be used to direct or route the programming signals towards the intended memory cell. The programming unit 35 may generate select signals 'SEL' for the selection logic circuitry 36 in conjunction with the different programming signals 'VPRG'.

FIG. 4 shows yet another variant of a programmable voltage generator that can be used in driver circuits in accordance with embodiments of the invention. The programmable voltage generator 40 differs from the voltage generator of FIG. 2 in that an additional access transistor 37-1 is provided between the first resistive element 22 and the input terminal 29-1, which allows disabling of the output signal 'OUT' whenever the access transistor 37-1 is switched off. Additionally, the programmable voltage generator 40 comprises an isolation unit 48, which isolates the output signal 'OUT' from the voltage 'V0' and stabilizes the output signal with regard to variations in the input impedance related to the probabilistic bit generators. The isolation unit 48 may be one of the following: a voltage follower circuit, a voltage buffer, a transimpedance amplifier.

Embodiments of the invention are not limited to the single-stage or two-staged voltage divider circuits of the preceding embodiments, but may include additional programmable and/or non-programmable divider stages. By way of example, each programmable voltage generator of a driver circuit according to another embodiment of the invention may include N programmable divider stages, followed by N-1 non-programmable divider stages and one reference resistor as the resistive element positioned last in the series of resistive elements. The resistances of the N programmable stages may be switchable magnetoresistances, e.g. MTJs, whose resistance values can be individually set to either one of a high resistance state (R-HRS) and a low resistance state (R-LRS). The resistances of the N-1 non-programmable divider stages and the reference resistor may be chosen to be equal to the value of the high resistance state (R-HRS). The output signal 'VOUT' may be the voltage signal at the electrical connection between the Nth programmable divider stage and the first non-programmable divider stage. In such an embodiment, the output voltage can be varied stepwise between a low output voltage, VOUT(LOW) = VDD*(R-LRS)/(R-LRS + R-HRS) = VDD/TRM, and high output voltage, VOUT(HIGH) = VDD/2 = VDD*(R-HRS)/(R-HRS + R-HRS). Here, 'VDD' is the common supply voltage to each programmable voltage generator and 'TMR' designates the tunnel magnetoresistance ratio TMR = [(R-HMS) - (R-LRS)]/(R-RLS). Therefore, the lower output voltage depends on the specific TMR parameter of the MTJs used as the programmable resistances. Although the example of N identical MTJs as programmable resistances has been discussed, this choice is not limiting. Other embodiments of the invention may include N different MTJs as programmable resistances, e.g., having different TMR coefficients and/or different resistance values in one or both of the high resistance state and the low resistance state. Likewise, the number of non-programmable divider stages may be different from N-1, e.g. both lower or higher number of non-programmable divider stages are possible. Moreover, the non-programmable divider stages may also include MTJs, but these are not programmable, e.g. are not connected in series to a program control transistor and are thus not part of a memory cell as understood in the context of the present invention.

In the programmable voltage generators of the preceding embodiments, only one resistive element has been shown per divider stage. Nonetheless, multiple successive resistive elements of the voltage divider circuit may be grouped together to form one divider stage of the voltage divider circuit, e.g. form a distributed resistance with respect to the divider stage of the voltage divider circuit.

A single-stage voltage divider circuit may be sufficient in embodiments of the invention in which the programmable resistance can be programmed in an analog manner, e.g., a continuum of resistance values can be programmed. Phase-change memory-based memristors, resistive RAM-based memristors, or conductive-bridge RAM-based memristors may be used as programmable resistive element of memory cells associated with the single programmable divider stage. The output signal can thus be changed continuously within a permitted range of output signals.

In embodiments of the invention that use discretely programmable resistive elements, such as switchable two-level or multi-level magnetoresistances, in memory cells associated with programmable divider stages of the divider circuit, the resulting output signals can only be changed incrementally. It is therefore beneficial to increase the number of attainable output signal levels and output signal resolution by choosing multi-staged voltage divider circuits instead of single-stage voltage divider circuits.

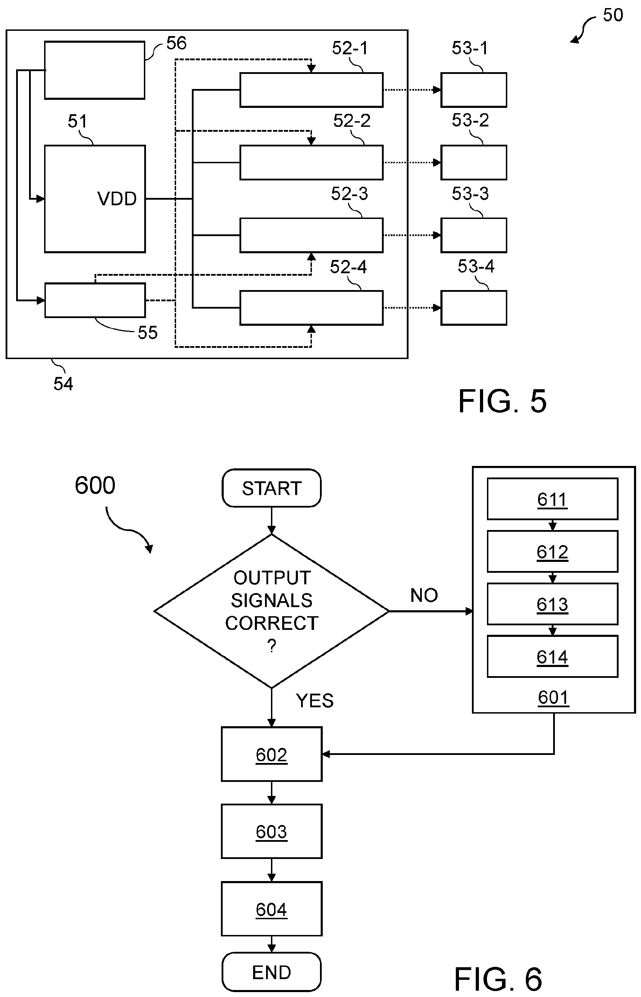

A driver circuit in accordance with embodiments of the invention is shown in FIG. 5. The driver circuit 54 comprises a voltage source 51 and a plurality of programmable voltage generators 52-1 to 52-4, which may be implemented as explained hereinabove. The voltage source 51 supplies a single supply voltage 'VDD', which is common to all programmable voltage generators 52-1 to 52-4. The input terminals of the plurality of programmable voltage generators 52-1 to 52-4 are jointly connected to the output of the voltage source 51. The output terminal of each programmable voltage generator 52-1 to 52-4 is connected to a control input connector of a corresponding one of the plurality of probabilistic bit generators 53-1 to 53-4. The output signals of the programmable voltage generators are thus driven to the corresponding control input connectors of the probabilistic bit generators when the driver circuit 54 is operated in the drive mode. The output signals are disabled when the driver circuit 54 is operated in the programming mode or the quiescent mode (i.e., power saving mode). The driver circuit 54 further comprises a global programming unit 55 and a control unit 56. The programming unit 55 is configured to generate a sequence of programming pulses in accordance with a targeted output level for the output signal to be generated by each voltage generator 52-1 to 54-1. Upon selection of programmable voltage generator for programming, the programming unit 55 may address the different memory cells of the selected voltage generator sequentially and apply a subsequence of programming pulses to the control gate of the program control transistor of the addressed memory cell. The control unit 56 is configured to generate a set of control signals in accordance with a mode of operation for the driver circuit, which includes the drive mode and the programming mode. In embodiments of the invention, the control unit 56 may control the access transistors of the programmable voltage generators 52-1 to 52-4 directly or indirectly via the programming unit 55.

The present invention also relates to a device for generating multiple tunable probabilistic bits, which comprises a driver circuit in accordance with embodiments of the invention, a single voltage supply source, and a plurality of tunable probabilistic bit generators. An input terminal of each probabilistic bit generator allows to individually control a statistical expectation of probabilistic bits generated by the probabilistic bit generator. FIG. 5 depicts a device 50 for generating multiple tunable probabilistic bits. Tunable probabilistic bit generators based on magnetic tunnel junction stacks formed over an SOT track (spin orbit torque) have been described, e.g., in P. Debashis, et al. "Gaussian Random Number Generator With Reconfigurable Mean and Variance Using Stochastic Magnetic Tunnel Junctions", IEEE Magnetics Letters, vol. 13, pp. 1-5, 2022. Therein, the SOT current influences the random switching behavior of the magnetoresistance of the MJT stack.

The present invention also relates to a method of simultaneously controlling the statistical expectations of probabilistic bit streams generated by multiple the probabilistic bit generator, which uses the driver circuit of embodiments of the previous aspect of the invention. The steps of an exemplary method 600 are briefly described with reference to FIG. 6.

Assuming that the output signals of the programmable voltage generator are correctly said to their target levels, the control gates of the program control transistors in the memory cells of each voltage generator are switched off in step 602. This may include disconnecting the control gates from the programming unit and/or applying a below threshold voltage to the control gates. If one or more output signals of the programmable voltage generator are incorrect, a programming step 601 are performed first. A common supply voltage is then supplied to the input terminals of the plurality of programmable voltage generators of the driver circuit in step 603. Next, the resistive element positioned first in the series of resistive elements of each voltage generator is connected to the input terminal of the voltage generator and the resistive element positioned last in the series of resistive elements of each voltage generator is connected to a fixed reference voltage in step 604. This may include switching on the access transistors of each voltage generator, e.g. by the applying an enable signal to the control gates of the access transistors of each voltage generator. If the driver circuit is no longer used to control the multiple probabilistic bits, the enable signal may be temporarily removed from the control gate of the access transistors of each voltage generator. This disables the output signals of the voltage generator.

The programming step 601 includes the following sub-steps:

Selecting a voltage generator of the plurality of programmable voltage generators for which the output signal is incorrect in step 611.

Generating a sequence of programming pulses in accordance with a target level for the output signal to be supplied by the selected voltage generator in step 612.

Disconnecting the resistive element positioned last in the series of resistive elements of the selected voltage generator from the fixed reference voltage in step 613. This may include switching off the access transistors of the selected voltage generator, e.g. by the removing an enable signal to the control gates of the access transistors of the selected voltage generator.

Sequentially driving the control gates of the different program control transistors in the memory cells of the selected voltage generator with the sequence of programming pulses or part of the sequence of programming pulses in step 614, thereby switching on and off a programming current through the programmable resistance addressed by the program control transistor. During step 614, the control gate of only one program control transistors is driven at a time by the sequence of programming pulses or part of the sequence of programming pulses, while the remainder of the program control transistors of the selected voltage generator is switched off. Furthermore, the resistive element positioned first in the series of resistive elements of the selected voltage generator is operatively connected to the input terminal of the selected voltage generator throughout step 614. If an access transistor is present between the input terminal and the resistive element positioned first in the series of resistive elements of the selected voltage generator, then a constant above threshold voltage or the sequence of programming pulses may be applied to the control gate this access transistor.

The sub-steps 612 through 614 may be repeated with respect to any further voltage generator whose output signal is not yet correctly set.

In embodiments of the invention, various programming schemes based on pulse sequences may be used, e.g., in step 614 of the method 600 in FIG.6. By way of example, an appropriate programming scheme with respect to discrete MTJs as programmable resistances consists of using a single write pulse of a predetermined pulse width in each programming pulse sequence/sub-sequence. On the other hand, ReRAM-based or phase change memory-based programmable resistances may use one of the following pulsed programming schemes: pulse amplitude coding, pulse width coding, incremental write/verify pulsed programming, or combinations thereof.

In embodiments of the invention, the input terminal of a voltage generator selected for programming may receive a different voltage than the voltage that is applied to the input terminal in the drive mode.

A driver circuit in accordance with embodiments of the invention may further comprise a readout unit for detecting the magnitude of the output signals generated by the different programmable voltage generators. This has the advantage that drifts or offsets in the output signals can be detected and compensated by re-programming the programmable divider stages based on an error signal indicative of the amount of detected offset or drift. A readout unit is also useful in embodiments of the invention in which incremental write/verify pulsed programming techniques are used.

The invention may be practiced in many ways and is not limited to the disclosed embodiments. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. Any reference signs in the claims should not be construed as limiting the scope.

## Claims

1. A programmable driver circuit (54) for simultaneously controlling multiple tunable probabilistic bit generators (53), each probabilistic bit generator having an input terminal for individually controlling a statistical expectation of probabilistic bits generated by the probabilistic bit generator, the driver circuit comprising:
a plurality of programmable voltage generators (52; 30), each voltage generator having an input terminal (29-1) and an output terminal (29-2) and being configured to generate a respective output signal of the driver circuit when operated in a drive mode, the input terminals of the plurality of programmable voltage generators being jointly connectible to a single voltage supply source, the output terminal of each voltage generator being directly connectible to the input terminal of a respective one of the multiple tunable probabilistic bit generators for driving the output signal generated by the voltage generator to the tunable probabilistic bit generator;
a programming unit (35) configured to generate a sequence of programming pulses in accordance with a target level for the output signal to be generated by each voltage generator;
wherein each voltage generator comprises:
a single-stage or multi-stage voltage divider circuit (31) formed by a series of resistive elements (32-1; 32-2; 33), the resistive element positioned first in said series of resistive elements being operatively connectible to the input terminal for receiving a supply voltage from the single voltage supply source and the resistive element positioned last in said series of resistive elements being operatively connectible to a fixed reference voltage, the output terminal of the voltage generator being operatively coupled to an electrical connection between two successive resistive elements of said series of resistive elements, whereby a voltage signal at said electrical connection between said two successive resistive elements determines the output signal at the output terminal when the voltage generator is operated in the drive mode;
a non-volatile memory unit (34a-b) comprising at least said resistive element positioned first in said series of resistive elements as a programmable resistance and a program control transistor (34-1) connected in series between the programmable resistance and the fixed reference voltage, a control gate of the program control transistor being operatively coupled to the programming unit to receive the sequence of programming pulses for the programmable voltage generator when operated in a programming mode.

2. The circuit of claim 1, wherein at least one of the plurality of voltage generators further comprises a voltage follower circuit interposed between the output terminal of the voltage generator and the electrical connection between the two successive resistive elements of the series of resistive elements of the voltage generator.

3. The circuit of claim 1, wherein at least one of the plurality of voltage generators further comprises a transconductance amplifier circuit interposed between the output terminal of the voltage generator and the electrical connection between the two successive resistive elements of the series of resistive elements of the voltage generator.

4. The circuit according to any one of the preceding claims, wherein each voltage generator further comprises a first access transistor for operatively connecting the resistive element positioned first in said series of resistive elements to the single voltage supply source and a second access transistor for operatively connecting the resistive element positioned last in said series of resistive elements to the fixed reference voltage.

5. The circuit according to any one of the claims 1 to 4, wherein a resistance value of the programmable resistance of the non-volatile memory unit of each voltage generator is programmable, by the sequence of programming pulses, to any analog value in a range between a lower resistance value and an upper resistance value.

6. The circuit of claim 5, wherein the programmable resistance of the non-volatile memory unit is one of the following: phase-change memory-based memristor, resistive RAM-based memristor, conductive-bridge RAM-based memristor.

7. The circuit according to any one of the claims 1 to 4, wherein a resistance value of the programmable resistance of the non-volatile memory unit of each voltage generator is programmable, by the sequence of programming pulses, to a set of digital values including at least a lower resistance value and an upper resistance value, and optionally including one or more intermediate resistance values in a range between the lower resistance value and the upper resistance value.

8. The circuit of claim 7, wherein the programmable resistance of the non-volatile memory unit is a switchable magnetoresistance.

9. The circuit according to any one of the preceding claims, the voltage divider circuit being multi-staged, wherein the non-volatile memory unit of each voltage generator comprises a plurality of non-volatile memory cells, a first memory cell of the plurality of non-volatile memory cells comprising the resistive element positioned first in said series of resistive elements as a programmable resistance and a first program control transistor connected in series between the programmable resistance and the fixed reference voltage, and each of the remaining memory cells of plurality of non-volatile memory cells comprising a respective intermediate resistive element of the series of resistive elements as a programmable resistance and a separate program control transistor connected in series between the programmable resistance and the fixed reference voltage, a control gate of each program control transistor of the non-volatile memory unit being selectively connectible to the programming unit to receive the sequence of programming pulses for the programmable voltage generator when operated in a programming mode .

10. The circuit of claim 9, wherein the programmable resistance of each memory cell of the non-volatile memory unit is a switchable magnetoresistance, wherein a lower resistance state of said switchable magnetoresistance differs across the different memory cells of the non-volatile memory unit.

11. A device for generating multiple tunable probabilistic bits, comprising:
a plurality of tunable probabilistic bit generators, each probabilistic bit generator having an input terminal for individually controlling a statistical expectation of probabilistic bits generated by the probabilistic bit generator;
a single voltage supply source;
a programmable driver circuit according to any one of the preceding claims, the input terminals of the plurality of programmable voltage generators of the programmable driver circuit being jointly connected to the single voltage supply source, and the output terminal of each voltage generator of the programmable driver circuit being directly connected to the input terminal of a respective one of the multiple tunable probabilistic bit generators for driving the output signal generated by the voltage generator to the tunable probabilistic bit generator.

12. A method of operating the driver circuit of any one of claims 1 to 10, comprising the steps of:
supplying a single voltage supply signal to the input terminals of the plurality of programmable voltage generators;
connecting the resistive element positioned first in said series of resistive elements of each voltage generator to the input terminal of the voltage generator;
connecting the resistive element positioned last in said series of resistive elements of each voltage generator to a fixed reference voltage;
disconnecting the control gate of each program control transistor in each voltage generator from the programming unit.

13. The method of claim 12, further comprising the steps of:
providing a plurality of tunable probabilistic bit generators, each probabilistic bit generator having an input terminal for individually controlling a statistical expectation of probabilistic bits generated by the probabilistic bit generator;
driving the output signals generated by each voltage generator to the input terminal of a respective one of the plurality of tunable probabilistic bit generators.

14. The method according to claim 12 or 13, wherein the output signals of the programmable driver circuit as generated by the plurality of programmable voltage generators is a voltage signal or a current signal.

15. The method according to claim 12, further comprising the steps of:
selecting a voltage generator of the plurality of programmable voltage generators for programming a target level for the output signal to be generated by the voltage generator when operated in the drive mode;
generating a sequence of programming pulses in accordance with the target level for the output signal of the selected voltage generator of the previous step;
disconnecting the resistive element positioned last in said series of resistive elements of the selected voltage generator from the fixed reference voltage;
sequentially coupling the programming unit to the control gates of the different program control transistors in the selected voltage generator and driving each control gate with the sequence of programming pulses or part of the sequence of programming pulses generated in the previous step, thereby switching on and off a programming current through the programmable resistance addressed by the program control transistor.

## Patentansprüche

1. Eine programmierbare Treiberschaltung (54) zum gleichzeitigen Steuern mehrerer abstimmbarer probabilistischer Bitgeneratoren (53), wobei jeder probabilistische Bitgenerator einen Eingangsanschluss zum individuellen Steuern eines statistischen Erwartungswerts von vom probabilistischen Bitgenerator erzeugten probabilistischen Bits aufweist, wobei die Treiberschaltung Folgendes umfasst:
- eine Vielzahl programmierbarer Spannungsgeneratoren (52; 30), wobei jeder Spannungsgenerator einen Eingangsanschluss (29-1) und einen Ausgangsanschluss (29-2) aufweist und so konfiguriert ist, dass er, wenn er im Ansteuermodus betrieben wird, ein entsprechendes Ausgangssignal der Treiberschaltung erzeugt, wobei die Eingangsanschlüsse der Vielzahl programmierbarer Spannungsgeneratoren gemeinsam mit einer einzigen Spannungsversorgungsquelle verbunden werden können, wobei der Ausgangsanschluss jedes Spannungsgenerators direkt mit dem Eingangsanschluss eines jeweiligen der mehreren abstimmbaren probabilistischen Bitgeneratoren verbunden werden kann, um das vom Spannungsgenerator erzeugte Ausgangssignal an den abstimmbaren probabilistischen Bitgenerator weiterzuleiten;
- eine Programmiereinheit (35), die so konfiguriert ist, dass sie eine Folge von Programmierimpulsen entsprechend einem Zielpegel für das von jedem Spannungsgenerator zu erzeugende Ausgangssignal erzeugt;
- wobei jeder Spannungsgenerator Folgendes umfasst:
- eine ein- oder mehrstufige Spannungsteilerschaltung (31), die aus einer Reihe von Widerstandselementen (32-1; 32-2; 33) gebildet ist, wobei das erste Widerstandselement in dieser Reihe von Widerstandselementen mit dem Eingangsanschluss operativ verbunden werden kann, um eine Versorgungsspannung von der einzigen Spannungsquelle zu empfangen, und das letzte Widerstandselement in dieser Reihe von Widerstandselementen mit einer festen Referenzspannung operativ verbunden werden kann, wobei der Ausgangsanschluss des Spannungsgenerators mit einer elektrischen Verbindung zwischen zwei aufeinanderfolgenden Widerstandselementen der Reihe von Widerstandselementen operativ gekoppelt ist, wodurch ein Spannungssignal an der elektrischen Verbindung zwischen den beiden aufeinanderfolgenden Widerstandselementen das Ausgangssignal am Ausgangsanschluss bestimmt, wenn der Spannungsgenerator im Ansteuermodus betrieben wird;
- eine nichtflüchtige Speichereinheit (34a-b), die mindestens das Widerstandselement, das als erstes in der Reihe von Widerstandselementen als programmierbarer Widerstand positioniert ist, und einen Programmsteuertransistor (34-1) umfasst, der in Reihe zwischen dem programmierbaren Widerstand und der festen Referenzspannung verbunden ist, wobei ein Steuergate des Programmsteuertransistors mit der Programmiereinheit operativ gekoppelt ist, um die Folge von Programmierimpulsen für den programmierbaren Spannungsgenerator zu empfangen, wenn dieser im Programmiermodus betrieben wird.

2. Die Schaltung nach Anspruch 1, wobei mindestens einer der Vielzahl von Spannungsgeneratoren ferner eine Spannungsfolgerschaltung umfasst, die zwischen dem Ausgangsanschluss des Spannungsgenerators und der elektrischen Verbindung zwischen den beiden aufeinanderfolgenden Widerstandselementen der Reihe von Widerstandselementen des Spannungsgenerators eingefügt ist.

3. Die Schaltung nach Anspruch 1, wobei mindestens einer der Vielzahl von Spannungsgeneratoren ferner eine Transkonduktanzverstärkerschaltung umfasst, die zwischen dem Ausgangsanschluss des Spannungsgenerators und der elektrischen Verbindung zwischen den beiden aufeinanderfolgenden Widerstandselementen der Reihe von Widerstandselementen des Spannungsgenerators eingefügt ist.

4. Die Schaltung nach einem der vorstehenden Ansprüche, wobei jeder Spannungsgenerator ferner einen ersten Zugangstransistor zum operativen Verbinden des ersten Widerstandselements in der Reihe von Widerstandselementen mit der einzigen Spannungsquelle und einen zweiten Zugangstransistor zum operativen Verbinden des letzten Widerstandselements in der Reihe von Widerstandselementen mit der festen Referenzspannung umfasst.

5. Die Schaltung nach einem der Ansprüche 1 bis 4, wobei der Widerstandswert des programmierbaren Widerstands der nichtflüchtigen Speichereinheit jedes Spannungsgenerators durch die Folge von Programmierimpulsen auf einen beliebigen Analogwert in einem Bereich zwischen einem unteren Widerstandswert und einem oberen Widerstandswert programmiert werden kann.

6. Die Schaltung nach Anspruch 5, wobei der programmierbare Widerstand der nichtflüchtigen Speichereinheit einer der folgenden ist: Memristor auf Basis eines Phasenwechselspeichers, Memristor auf Basis eines resistiven RAMs, Memristor auf Basis eines leitfähigen Brücken-RAMs.

7. Die Schaltung nach einem der Ansprüche 1 bis 4, wobei ein Widerstandswert des programmierbaren Widerstands der nichtflüchtigen Speichereinheit jedes Spannungsgenerators durch die Folge von Programmierimpulsen auf eine Menge digitaler Werte programmiert werden kann, die mindestens einen unteren Widerstandswert und einen oberen Widerstandswert sowie optional einen oder mehrere Zwischenwiderstandswerte in einem Bereich zwischen dem unteren Widerstandswert und dem oberen Widerstandswert beinhaltet.

8. Die Schaltung nach Anspruch 7, wobei der programmierbare Widerstand der nichtflüchtigen Speichereinheit ein schaltbarer Magnetowiderstand ist.

9. Die Schaltung nach einem der vorstehenden Ansprüche, wobei die Spannungsteilerschaltung mehrstufig ist, wobei die nichtflüchtige Speichereinheit jedes Spannungsgenerators eine Vielzahl von nichtflüchtigen Speicherzellen umfasst, eine erste Speicherzelle der Vielzahl von nichtflüchtigen Speicherzellen das erste Widerstandselement der Reihe von Widerstandselementen als programmierbaren Widerstand und einen ersten Programmsteuertransistor, der in Reihe zwischen dem programmierbaren Widerstand und der festen Referenzspannung verbunden ist, umfasst, und jede der übrigen Speicherzellen der Vielzahl von nichtflüchtigen Speicherzellen ein jeweiliges Zwischenwiderstandselement der Reihe von Widerstandselementen als programmierbaren Widerstand und einen separaten Programmsteuertransistor, der in Reihe zwischen dem programmierbaren Widerstand und der festen Referenzspannung verbunden ist, umfasst, wobei ein Steuergate jedes Programmsteuertransistors der nichtflüchtigen Speichereinheit wahlweise mit der Programmiereinheit verbunden werden kann, um die Folge von Programmierimpulsen für den programmierbaren Spannungsgenerator im Programmiermodus zu empfangen.

10. Die Schaltung nach Anspruch 9, wobei der programmierbare Widerstand jeder Speicherzelle der nichtflüchtigen Speichereinheit ein schaltbarer Magnetowiderstand ist, wobei sich ein niedriger Widerstandszustand des schaltbaren Magnetowiderstands in den verschiedenen Speicherzellen der nichtflüchtigen Speichereinheit unterscheidet.

11. Eine Vorrichtung zur Erzeugung mehrerer abstimmbarer Wahrscheinlichkeitsbits, umfassend:
- eine Vielzahl von abstimmbaren probabilistischen Bitgeneratoren, wobei jeder probabilistische Bitgenerator einen Eingangsanschluss zur individuellen Steuerung eines statistischen Erwartungswerts von vom probabilistischen Bitgenerator erzeugten probabilistischen Bits aufweist;
- eine einzige Spannungsquelle;
- eine programmierbare Treiberschaltung nach einem der vorstehenden Ansprüche, wobei die Eingangsanschlüsse der Vielzahl programmierbarer Spannungsgeneratoren der programmierbaren Treiberschaltung gemeinsam mit der einzigen Spannungsversorgungsquelle verbunden sind und der Ausgangsanschluss jedes Spannungsgenerators der programmierbaren Treiberschaltung direkt mit dem Eingangsanschluss eines jeweiligen der mehreren abstimmbaren probabilistischen Bitgeneratoren verbunden ist, um das vom Spannungsgenerator erzeugte Ausgangssignal an den abstimmbaren probabilistischen Bitgenerator weiterzuleiten.

12. Ein Verfahren zum Betreiben der Treiberschaltung nach einem der Ansprüche 1 bis 10, wobei das Verfahren die folgenden Schritte umfasst:
- Bereitstellen eines einzigen Spannungsversorgungssignals für die Eingangsanschlüsse der Vielzahl programmierbarer Spannungsgeneratoren;
- Verbinden des ersten Widerstandselements in der Reihe von Widerstandselementen jedes Spannungsgenerators mit dem Eingangsanschluss des Spannungsgenerators;
- Verbinden des letzten Widerstandselements in der Reihe von Widerstandselementen jedes Spannungsgenerators mit einer festen Referenzspannung;
- Trennen des Steuergates jedes Programmsteuertransistors in jedem Spannungsgenerator von der Programmiereinheit.

13. Das Verfahren nach Anspruch 12, ferner umfassend die folgenden Schritte:
- Bereitstellen einer Vielzahl von abstimmbaren probabilistischen Bitgeneratoren, wobei jeder probabilistische Bitgenerator einen Eingangsanschluss zum individuellen Steuern eines statistischen Erwartungswerts von vom probabilistischen Bitgenerator erzeugten probabilistischen Bits aufweist;
- Weiterleiten der von jedem Spannungsgenerator erzeugten Ausgangssignale an den Eingangsanschluss eines jeweiligen der mehreren abstimmbaren probabilistischen Bitgeneratoren.

14. Verfahren nach Anspruch 12 oder 13, wobei die Ausgangssignale der programmierbaren Treiberschaltung, die von einer Vielzahl programmierbarer Spannungsgeneratoren erzeugt werden, ein Spannungssignal oder ein Stromsignal sind.

15. Das Verfahren nach Anspruch 12, ferner umfassend die folgenden Schritte:
- Auswählen eines Spannungsgenerators der Vielzahl programmierbarer Spannungsgeneratoren zur Programmierung eines Zielpegels für das vom Spannungsgenerator zu erzeugende Ausgangssignal, wenn er im Ansteuermodus betrieben wird;
- Erzeugen einer Folge von Programmierimpulsen entsprechend dem Zielpegel für das Ausgangssignal des ausgewählten Spannungsgenerators aus dem vorherigen Schritt;
- Trennen des letzten Widerstandselements in der Reihe von Widerstandselementen des ausgewählten Spannungsgenerators von der festen Referenzspannung;
- sequenzielles Koppeln der Programmiereinheit mit den Steuergates der verschiedenen Programmsteuertransistoren im ausgewählten Spannungsgenerator und Ansteuern jedes Steuergates mit der im vorherigen Schritt erzeugten Folge von Programmierimpulsen oder einem Teil der Folge von Programmierimpulsen, wodurch ein Programmierstrom durch den vom Programmsteuertransistor adressierten programmierbaren Widerstand ein- und ausgeschaltet wird.

## Revendications

1. Un circuit de commande programmable (54) pour contrôler simultanément plusieurs générateurs de bits probabilistes réglables (53), chaque générateur de bits probabilistes ayant une borne d'entrée pour contrôler individuellement une espérance statistique de bits probabilistes générés par le générateur de bits probabilistes, le circuit de commande comprenant :
une pluralité de générateurs de tension programmables (52; 30), chaque générateur de tension ayant une borne d'entrée (29-1) et une borne de sortie (29-2) et étant configuré pour générer un signal de sortie respectif du circuit de commande lorsqu'il est utilisé en mode de commande, les bornes d'entrée de la pluralité de générateurs de tension programmables étant connectables conjointement à une source d'alimentation en tension unique, la borne de sortie de chaque générateur de tension étant directement connectable à la borne d'entrée d'un des multiples générateurs de bits probabilistes réglables pour piloter le signal de sortie généré par le générateur de tension vers le générateur de bits probabilistes réglable ;
une unité de programmation (35) configurée pour générer une séquence d'impulsions de programmation conformément à un niveau cible pour le signal de sortie à générer par chaque générateur de tension ;
dans lequel chaque générateur de tension comprend :
un circuit diviseur de tension à un étage ou à plusieurs étages (31) formé par une série d'éléments résistifs (32-1; 32-2; 33), l'élément résistif positionné en premier dans ladite série d'éléments résistifs étant connectable de manière opérative à la borne d'entrée pour recevoir une tension d'alimentation de la source d'alimentation en tension unique et l'élément résistif positionné en dernier dans ladite série d'éléments résistifs étant connectable de manière opérative à une tension de référence fixe, la borne de sortie du générateur de tension étant couplée de manière opérative à une connexion électrique entre deux éléments résistifs successifs de ladite série d'éléments résistifs, de sorte qu'un signal de tension à ladite connexion électrique entre lesdits deux éléments résistifs successifs détermine le signal de sortie à la borne de sortie lorsque le générateur de tension est utilisé en mode de commande ;
une unité de mémoire non volatile (34a-b) comprenant au moins ledit élément résistif positionné en premier dans ladite série d'éléments résistifs en tant que résistance programmable et un transistor de commande de programme (34-1) connecté en série entre la résistance programmable et la tension de référence fixe, une grille de commande du transistor de commande de programme étant couplée de manière opérative à l'unité de programmation pour recevoir la séquence d'impulsions de programmation pour le générateur de tension programmable lorsqu'il est utilisé en mode de programmation.

2. Le circuit de la revendication 1, dans lequel au moins un des générateurs de tension de la pluralité comprend en outre un circuit suiveur de tension interposé entre la borne de sortie du générateur de tension et la connexion électrique entre les deux éléments résistifs successifs de la série d'éléments résistifs du générateur de tension.

3. Le circuit de la revendication 1, dans lequel au moins un des générateurs de tension de la pluralité comprend en outre un circuit amplificateur de transconductance interposé entre la borne de sortie du générateur de tension et la connexion électrique entre les deux éléments résistifs successifs de la série d'éléments résistifs du générateur de tension.

4. Le circuit selon l'une quelconque des revendications précédentes, dans lequel chaque générateur de tension comprend en outre un premier transistor d'accès pour connecter de manière opérative l'élément résistif positionné en premier dans ladite série d'éléments résistifs à la source d'alimentation en tension unique et un second transistor d'accès pour connecter de manière opérative l'élément résistif positionné en dernier dans ladite série d'éléments résistifs à la tension de référence fixe.

5. Le circuit selon l'une quelconque des revendications 1 à 4, dans lequel une valeur de résistance de la résistance programmable de l'unité de mémoire non volatile de chaque générateur de tension est programmable, par la séquence d'impulsions de programmation, à toute valeur analogique dans une plage comprise entre une valeur de résistance inférieure et une valeur de résistance supérieure.

6. Le circuit de la revendication 5, dans lequel la résistance programmable de l'unité de mémoire non volatile est l'un des éléments suivants : memristor basé sur la mémoire à changement de phase, memristor basé sur la RAM résistive, memristor basé sur la RAM à pont conducteur.

7. Le circuit selon l'une quelconque des revendications 1 à 4, dans lequel une valeur de résistance de la résistance programmable de l'unité de mémoire non volatile de chaque générateur de tension est programmable, par la séquence d'impulsions de programmation, à un ensemble de valeurs numériques comprenant au moins une valeur de résistance inférieure et une valeur de résistance supérieure, et comprenant éventuellement une ou plusieurs valeurs de résistance intermédiaires dans une plage comprise entre la valeur de résistance inférieure et la valeur de résistance supérieure.

8. Le circuit de la revendication 7, dans lequel la résistance programmable de l'unité de mémoire non volatile est une magnétorésistance commutable.

9. Le circuit selon l'une quelconque des revendications précédentes, le circuit diviseur de tension étant à plusieurs étages, dans lequel l'unité de mémoire non volatile de chaque générateur de tension comprend une pluralité de cellules de mémoire non volatile, une première cellule de mémoire de la pluralité de cellules de mémoire non volatile comprenant l'élément résistif positionné en premier dans ladite série d'éléments résistifs en tant que résistance programmable et un premier transistor de commande de programme connecté en série entre la résistance programmable et la tension de référence fixe, et chacune des cellules de mémoire restantes de la pluralité de cellules de mémoire non volatile comprenant un élément résistif intermédiaire respectif de la série d'éléments résistifs en tant que résistance programmable et un transistor de commande de programme séparé connecté en série entre la résistance programmable et la tension de référence fixe, une grille de commande de chaque transistor de commande de programme de l'unité de mémoire non volatile étant connectable de manière sélective à l'unité de programmation pour recevoir la séquence d'impulsions de programmation pour le générateur de tension programmable lorsqu'il est utilisé en mode de programmation.

10. Le circuit de la revendication 9, dans lequel la résistance programmable de chaque cellule de mémoire de l'unité de mémoire non volatile est une magnétorésistance commutable, dans lequel un état de résistance inférieur de ladite magnétorésistance commutable diffère entre les différentes cellules de mémoire de l'unité de mémoire non volatile.

11. Un dispositif pour générer plusieurs bits probabilistes réglables, comprenant :
une pluralité de générateurs de bits probabilistes réglables, chaque générateur de bits probabilistes ayant une borne d'entrée pour contrôler individuellement une espérance statistique de bits probabilistes générés par le générateur de bits probabilistes ;
une source d'alimentation en tension unique ;
un circuit de commande programmable selon l'une quelconque des revendications précédentes, les bornes d'entrée de la pluralité de générateurs de tension programmables du circuit de commande programmable étant conjointement connectées à la source d'alimentation en tension unique, et la borne de sortie de chaque générateur de tension du circuit de commande programmable étant directement connectée à la borne d'entrée d'un des multiples générateurs de bits probabilistes réglables pour piloter le signal de sortie généré par le générateur de tension vers le générateur de bits probabilistes réglable.

12. Un procédé de fonctionnement du circuit de commande selon l'une quelconque des revendications 1 à 10, comprenant les étapes de :
fournir un signal d'alimentation en tension unique aux bornes d'entrée de la pluralité de générateurs de tension programmables ;
connecter l'élément résistif positionné en premier dans ladite série d'éléments résistifs de chaque générateur de tension à la borne d'entrée du générateur de tension ;
connecter l'élément résistif positionné en dernier dans ladite série d'éléments résistifs de chaque générateur de tension à une tension de référence fixe ;
déconnecter la grille de commande de chaque transistor de commande de programme dans chaque générateur de tension de l'unité de programmation.

13. Le procédé de la revendication 12, comprenant en outre les étapes de :
fournir une pluralité de générateurs de bits probabilistes réglables, chaque générateur de bits probabilistes ayant une borne d'entrée pour contrôler individuellement une espérance statistique de bits probabilistes générés par le générateur de bits probabilistes ;
piloter les signaux de sortie générés par chaque générateur de tension vers la borne d'entrée d'un des générateurs de bits probabilistes réglables de la pluralité.

14. Le procédé selon la revendication 12 ou 13, dans lequel les signaux de sortie du circuit de commande programmable tels que générés par la pluralité de générateurs de tension programmables sont un signal de tension ou un signal de courant.

15. Le procédé selon la revendication 12, comprenant en outre les étapes de :
sélectionner un générateur de tension de la pluralité de générateurs de tension programmables pour programmer un niveau cible pour le signal de sortie à générer par le générateur de tension lorsqu'il est utilisé en mode de commande ;
générer une séquence d'impulsions de programmation conformément au niveau cible pour le signal de sortie du générateur de tension sélectionné à l'étape précédente ;
déconnecter l'élément résistif positionné en dernier dans ladite série d'éléments résistifs du générateur de tension sélectionné de la tension de référence fixe ;
coupler séquentiellement l'unité de programmation aux grilles de commande des différents transistors de commande de programme dans le générateur de tension sélectionné et piloter chaque grille de commande avec la séquence d'impulsions de programmation ou une partie de la séquence d'impulsions de programmation générée à l'étape précédente, activant et désactivant ainsi un courant de programmation à travers la résistance programmable adressée par le transistor de commande de programme.
